(19) Europäisches Patentamt
European Patent Office
Office européen des brevets

(11) **EP 1 754 264 B1**

(12) **EUROPEAN PATENT SPECIFICATION**

(45) Date of publication and mention
of the grant of the patent:
**14.08.2019 Bulletin 2019/33**

(51) Int Cl.:
***H01L 31/18*** (2006.01)      ***H01L 31/0288*** (2006.01)

(21) Application number: **05752878.8**

(22) Date of filing: **10.06.2005**

(86) International application number:
**PCT/NL2005/000422**

(87) International publication number:
**WO 2005/122287 (22.12.2005 Gazette 2005/51)**

(54) **METHOD FOR THE PRODUCTION OF CRYSTALLINE SILICON FOILS**

VERFAHREN ZUR HERSTELLUNG VON KRISTALLINEN SILIZIUMFOLIEN

PROCÉDÉ POUR LA PRODUCTION DE FILMS CRISTALLINS DE SILICIUM

(84) Designated Contracting States:
**AT BE BG CH CY CZ DE DK EE ES FI FR GB GR HU IE IS IT LI LT LU MC NL PL PT RO SE SI SK TR**

(30) Priority: **10.06.2004 NL 1026377**

(43) Date of publication of application:
**21.02.2007 Bulletin 2007/08**

(73) Proprietor: **RGS Development B.V.**
**1755 LE Petten (NL)**

(72) Inventor: **SCHÖNECKER, Axel Georg**
**1825 DN Alkmaar (NL)**

(74) Representative: **Nederlandsch Octrooibureau**
**P.O. Box 29720**
**2502 LS The Hague (NL)**

(56) References cited:
**EP-A- 1 063 706      DE-A1- 2 830 522**
**US-A- 4 236 947**

- **BELL R O ET AL: "EFFECT OF DOPING GRADIENTS ON SOLAR CELL EFFICIENCY" PHOTOVOLTAIC SPECIALISTS CONFERENCE. LAS VEGAS, OCT. 21 - 25, 1985, NEW YORK, IEEE, US, vol. 1 CONF. 18, 21 October 1985 (1985-10-21), pages 764-769, XP000132057 cited in the application**
- **MCCANN M J ET AL: "Boron doping of silicon layers grown by liquid phase epitaxy" JOURNAL OF CRYSTAL GROWTH, NORTH-HOLLAND PUBLISHING CO. AMSTERDAM, NL, vol. 241, no. 1-2, May 2002 (2002-05), pages 45-50, XP004358315 ISSN: 0022-0248 cited in the application**
- **J. P. KALEJS: "An overview of new developments in crystalline silicon ribbon material technology for solar cells" PROCEEDINGS OF THE 3RD WORLD CONFERENCE ON PHOTOVOLTAIC ENERGY CONVERSION, 11 May 2003 (2003-05-11), - 18 May 2003 (2003-05-18) XP002322098 OSAKA, JP**
- **BALIGA B J: "HIGH LIFETIME SILICON LIQUID PHASE EPITAXY" JOURNAL OF THE ELECTROCHEMICAL SOCIETY, ELECTROCHEMICAL SOCIETY. MANCHESTER, NEW HAMPSHIRE, US, vol. 129, no. 3, March 1982 (1982-03), pages 665-666, XP000841351 ISSN: 0013-4651**

**Description**

The invention relates to a method of producing of crystalline semiconductor foils with an integrated electric field, comprising:

- doping a fluid semiconductor with a doping substance having an equilibrium segregation coefficient $k_0$ where $k_0 << 1$,
- drawing a foil from a melting crucible containing said fluid semiconductor in a production direction.

Such a method is known per se. After the foil has been drawn the foil is divided into pieces. These pieces are then exposed to a diffusion process in which a doping substance is diffused into the foil. The method is suitable in particular for the production of rectangular solar cells that can easily be assembled to give solar panels. Here crystalline is understood to be both polycrystalline and monocrystalline material.

Solar cells consist of light-absorbent foil consisting of a semiconductor with an integral transition from a p-conducting to an n-conducting region therein. The principle of solar cells is that photons that have more energy than the energy between the conduction and valence band of the semiconductor generate charge carrier pairs (that is to say hole-electron pairs) when they are absorbed in the semiconductor material. The charge carriers diffuse through the semiconductor foil until they either traverse the p-n transition or recombine with a second charge carrier. If they have passed the p-n transition the charge carriers can supply electric power to an external electrical load. The efficiency of a solar cell is reduced by the recombination of charge carriers in a solar cell, where the separation energy of a charge carrier pair is converted back into heat and is not available as electrical energy. The efficiency of a solar cell is to a significant extent determined by the life of the charge carriers (that is to say the time between generation and recombination). If this life is long, it is then more probable that a charge carrier reaches the pn transition and contributes to the electric power.

In advanced solar cells the life of the charge carriers is very long. To a large extent all holes and electrons that are created by incident photons have sufficient time to diffuse to the other side of the transition and thus contribute to the power of the cell. However, the life of the charge carriers is based on physical properties of the semiconductor. Impurities in the material can add additional recombination sites, as a result of which the life will shorten. If the life of minority charge carriers decreases, more holes and electrons will recombine and disappear before they are able to make a contribution to the power of the cell. This gives rise to a poorer efficiency of the cell. One method for increasing this efficiency is to direct the incidental diffusion of the charge carrier towards the p-n transition in such a way that the likelihood of reaching the p-n transition within the life of the charge carrier is appreciably increased. This can be achieved by applying a drift field in the foil, as a result of which charge carriers are transported explicitly towards the pn transition (drift current) instead of diffusing incidentally. These solar cells are also termed drift cells. By applying a drift field the transport of charge carriers towards the pn transition is increased so that minority charge carriers that are generated relatively far away from the pn transition by incident solar radiation will also transverse the pn transition.

One option for producing such 'drift cells' is molecular beam epitaxy (MBE) in order to make cells with an increasing n+-n doping in order to create a strong drift field. Making drift cells by means of MBE is very expensive because of the method used. Another method is to diffuse doping substances at a high temperature into crystalline foils that have already been produced. Because of the low diffusion coefficient of the conventional doping substances this method is very slow and thus also relatively expensive.

In the publication by Bell R.O. et al.: "Effect of doping gradients on solar cell efficiency", Photovoltaic specialists conference, Las Vegas, Oct. 21-25, 1985 New York, IEEE, US, part VOL. 1 CONF. 18, 21 October 1985, pages 764-769 a study is described in which use was made of an edge-defined foil-fed growth (EFG) film drawing technique. The publication describes the possibility of obtaining a desired distribution of the doping in a crystallised (hollow tubular) foil with the aid of the correct doping substance concentration in the fluid silicon and a correct growth rate. In the case of EFG, crystallisation of the silicon proceeds inwards from two outer surfaces, the innermost portion of the foil remaining fluid for longest in the growth region. By means of segregation the concentration of doping substance in the fluid silicon is increased just in front of a crystallisation front. By inclusion of fluid silicon with a higher concentration between the two crystallisation fronts, maximum doping is obtained in the middle of the foil. With this method a crystallisation front has a horizontal growth rate component that is constant because the heat of crystallisation is dissipated by radiation. This component is so small that the effective segregation coefficient for a doping substance is equal to the equilibrium segregation coefficient. A consequence of this, which has already been mentioned, is accumulation of the doping substance in front of the crystallisation fronts.

Another method is described in the publication by McCann M.J. et al.: "Boron doping of silicon layers grown by liquid phase epitaxy", Journal of crystal growth, North-Holland Publishing co. Amsterdam, NL, part 241, no. 1-2, May 2002 pp. 45-50, where a liquid phase epitaxy (LPE) growth method is used and the active doping substance concentration in the melting crucible during the process is lowered by means of cluster formation of the doping substance (boron). As a result a specific doping profile is produced in the crystallised silicon layer.

J. P. Kalejs: "An overview of new developments in crystalline silicon ribbon material technology for solar cells", proceedings of the third world conference on photovoltaic energy conversion, 11 May 2003 - 18 May 2003, Osaka, Japan, describes crystalline silicon ribbon technology development inter alia, the horizontal growth technique Ribbon Growth on Substrate (RGS).

One aim of the present invention is to provide an alternative for the production of crystalline semiconductor layers with integral electric field.

Said aim is achieved by a method in accordance with claim 1.

Because the crystal growth speed varies and a doping substance with a suitable segregation coefficient is used, a doping gradient is obtained that is responsible for an integral drift field.

Preferably the heat of crystallisation is dissipated so rapidly that an initial crystal growth speed is so high that the effective segregation coefficient $k_{eff}$ is virtually equal to 1. As a result a doping profile can be created that has a desired high value on one side of the foil. This provides a drift field that is highly desirable in, for example, solar cells.

The semiconductor is preferably silicon. This semiconductor is, inter alia, very suitable for the production of solar cells. In order to enable the fluid silicon to crystallise it can, for example, be brought into contact with a substrate or with a grating, which have a lower temperature than that of the fluid silicon. Possible techniques that can be used for this are RGS (Ribbon Growth on Substrate), S-Web technique, see, for example, US 4 554 203, SSP (Silicon Sheets from Powder), see, for example, US 4 690 797. In all these techniques a foil is drawn where the crystal growth speed is perpendicular, or virtually perpendicular, to the production direction of the foil.

An additional advantage of these techniques is that a thermal resistance in the crystallised foil increases as the growth process proceeds, as a result of which the growth speed of the crystal automatically decreases.

Nevertheless, it can be necessary to exert an additional influence on the dissipation of heat from the crystallisation process in order thus to achieve the correct effect. One option in the case of the use of a substrate band is to increase the substrate temperature dynamically, as a result of which the growth speed decreases. The same applies for techniques where a grating is used, such as in the case of S-web.

Preferably a doping substance is used which has an equilibrium segregation coefficient $k_0$ of less than 0.01. It has been found that very good results are obtained making use of gallium ($k_0 = 0.008$) as doping substance in the silicon.

According to a further aspect, there is provided a crystalline semiconductor foil according to claim 10.

Further advantages and characteristics of the present invention will become apparent on the basis of a description of a few embodiments, where reference is made to the appended drawings, in which:

Fig. 1 is a diagrammatic side view of a foil casting device;
Fig. 2 is an example of the doping profile of a foil produced using the method according to the invention;
Fig. 3 is an example of the doping profile of the foil in Figure 2, where two additional diffusion steps are carried out;
Fig. 4 is a side view of a foil casting device where the crystal growth speed is actively influenced by means of a halogen lamp.

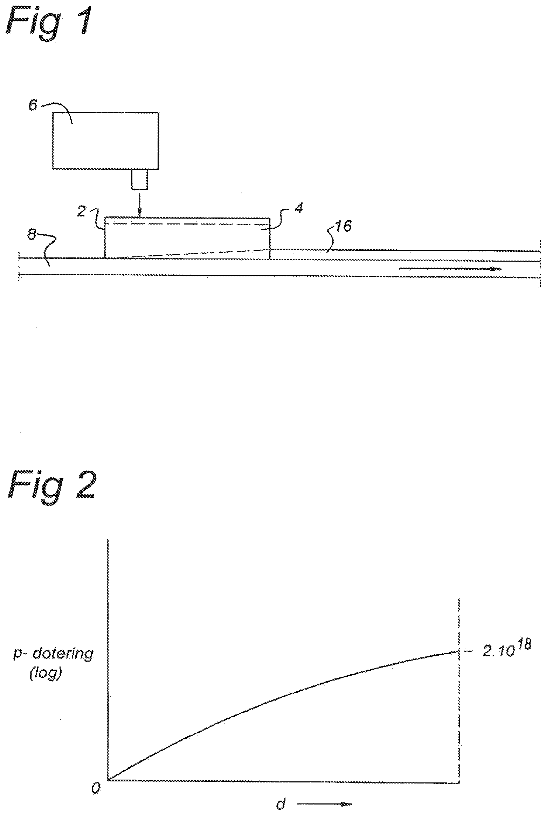

Figure 1 shows a diagrammatic side view of a foil casting device 1 with which a preferred embodiment of the present invention can be carried out. The device 1 consists of a casting frame 2 into which fluid silicon can be poured. The fluid silicon 4 is poured into the casting frame 2 with the aid of a feed device 6. Below the casting frame 2 there is a substrate band 8 that is set up to pass underneath the casting frame 2 at a specific speed. The drive installation required for this has not been drawn in Figure 1. The temperature of the substrate band 8 is set such that the fluid silicon 4 crystallises at the surface with the substrate band 8. Because the substrate band 8 is moving, to the right in Figure 1, a foil 16 will be produced on a downstream side of the casting frame 2. This foil 16 pushes the casting frame 2 upwards on the downstream side, as a result of which the casting frame tilts slightly. A foil is drawn in this way. The method described here is termed RGS (Ribbon Growth on Substrate). A major advantage of RGS is that a relatively large amount of foil can be produced per hour.

In the present invention the doping substance that produces an electric field is admixed into the fluid semiconductor. According to the present invention the semiconductor is doped with a doping substance that has a segregation coefficient $k_0$ that typically is less than 0.01. The segregation coefficient $k_0$ under equilibrium conditions, that is to say the equilibrium segregation coefficient, is defined as follows:

$$K_0 = C^s_0 / C^L_0 \qquad\qquad (1)$$

where $C^s_0$ is the solubility of the doping substance in the solid semiconductor and $C^L_0$ is the solubility in the fluid semiconductor at melt temperature.

The equilibrium segregation coefficient of boron in silicon is $k_0 = 0.8$. That is to say if the casting frame is filled with, for example, fluid silicon doped with boron, the boron prefers to be in the fluid silicon rather than in the solid silicon. However, the preference for boron to be in the fluid silicon is not extreme; after all, the equilibrium segregation coefficient is virtually equal to 1.0.

Crystallisations performed industrially typically take place at crystal growth speeds that no longer can be regarded as equilibrium situations. In these cases the difference in the concentration of impurities in the fluid phase and solid phase respectively is no longer described by the equilibrium segregation coefficient. In these cases the difference in concentration is determined by the effective segregation coefficient, which is defined as follows:

$$k_{eff} = k_0 / (k_0 + (1-k_0) \exp(-v\delta/D)) \qquad (2)$$

where $v$ is the crystal growth speed and $\delta$ the thickness of the enrichment zone (that is produced because at the high crystal growth speed insufficient time remains to distribute the raised impurity concentration in the fluid phase) in the fluid in front of the crystallisation front and $D$ is the diffusion rate of the impurities (doping substance) in the fluid phase.

Furthermore

$$k_{eff} = C^S_{eff} / C^L_0 \qquad (3)$$

where $C^S_{eff}$ is the concentration of the doping substance achieved in the solid silicon and $C^L_0$ is the solubility in the fluid semiconductor at melt temperature.

It follows from equation 2 that if the crystal growth speed $v$ is low the effective segregation coefficient $k_{eff}$ approaches the equilibrium segregation coefficient $k_0$. At a high crystal growth speed $v$ the effective segregation coefficient $k_{eff}$ approaches the value 1, which means that $C^S_{eff} = C^L_0$. That is to say the concentration achieved in the solid silicon is equal to the concentration in the fluid silicon irrespective of the value of $k_0$. If the crystal growth speed is changed from high to low, the effective segregation coefficient $k_{eff}$ will change from 1 to $k_0$.

This insight is used in the method according to the invention, in combination with a doping substance with a low segregation coefficient, in order to create a desired drift field. By making use of the foil casting principle, a varying crystal growth speed $v$ is achieved. With this procedure the temperatures of the substrate band 8 and the fluid silicon to be supplied can be kept (virtually) constant. During foil casting a crystallised layer 16 is produced on the surface of the substrate band. The crystallised layer 16 is thicker at the output end of the casting frame. A thicker crystal layer provides greater thermal resistance, which, in turn, ensures a lower crystal growth speed. The crystal growth speed $v$ thus decreases in a direction perpendicular to the substrate band 8. According to the invention a doping substance is used which has an equilibrium segregation coefficient $k_0$ that typically is less than 0.01. One example of such a doping substance is gallium, which has an equilibrium segregation coefficient $k_0$ of approximately 0.008. At a relatively high crystal growth speed $v$ the concentration of gallium in the solid silicon will be virtually the same as the concentration of gallium in the fluid silicon. The gallium doping on the substrate surface is thus virtually the same as the gallium doping in the fluid silicon supplied. If this value is, for example, $2 \times 10^{16}$ atoms per cm$^{-3}$, the gallium doping on the underside of the foil 16, that is to say the side of the substrate band 8, will also be approximately $2 \times 10^{16}$ atoms per cm$^{-3}$. However, because the crystal growth speed decreases in the direction perpendicular to the substrate band 8, the gallium doping in that direction will also decrease. After all, it follows from equations 2 and 3:

$$C^S_{eff} = C^L_0 \times k_0./(k_0 + (1-k_0) \exp(-v\delta/D)) \qquad (4)$$

and for gallium;

$$k_0 << 1 \qquad (5)$$

For a low speed $v$ it follows from equations 4 and 5 that:

$$C^S_{eff} = C^L_0 \times k_0 \qquad (6)$$

In other words the concentration of gallium will decrease in the crystallised silicon in the direction perpendicular to the substrate band 8. The gradient of this profile is such that the concentration of gallium is appreciably reduced towards the top surface of the silicon foil 16. This is a direct consequence of the very low equilibrium segregation coefficient $k_0$ of gallium. If, for example, boron ($k_0$ = 0.8) were to be used, this principle is barely effective.

Thus a silicon foil 16 has been produced with a variable p-type doping that generates a drift field in the silicon foil 16. A solar cell produced using a foil 16 produced in this way corresponds to the drift field cells from the state of the art. An example of a doping profile for a foil 16 that has been produced in accordance with the method of the invention is shown in Figure 2. In Figure 2 the distance from the surface of the foil 16 can be seen on the X axis and the level of the gallium doping achieved can be seen on the Y axis. In Figure 2 d = 0 corresponds to the top surface of the foil 16 in Figure 1.

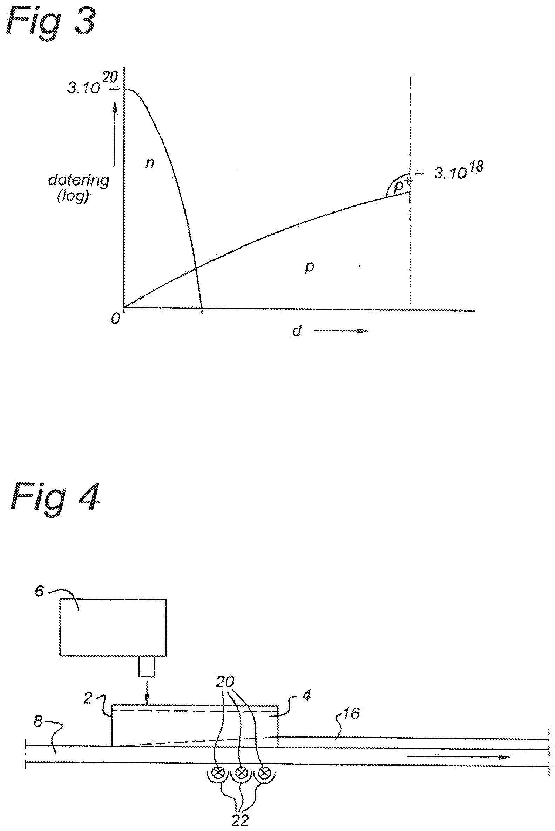

In one embodiment of the invention the silicon foil 16 is then doped with an n-type doping, so that a pn transition in the silicon foil 16 is produced. The additional n-type doping can, for example, be carried out making use of a diffusion process. The silicon foil 16 is then doped with, for example, a thin aluminium layer (p-type) on the underside of the foil 16. As a result a p+ region is produced in the silicon foil 16 in conjunction with metallization on the underside, so that a rear contact with good conductivity is produced. The result of these two additional steps is shown in Figure 3. In this figure the n-type doping, which in this example has a maximum value of $3 \times 10^{20}$, can be seen on the left-hand side. On the right-hand side it can be seen that in this example the p+ doping has a maximum value of $3 \times 10^{18}$. As a final step a conducting contact is made on the front, so that the foil 16 can be used as a solar cell that contains an integral drift field. Tests have shown that the efficiency of solar cells that have been made using the method according to the invention is increased by approximately 1%. This is an absolute percentage which in the field of solar cells, where an efficiency is of the order to magnitude of 14%, may be termed appreciable.

In one embodiment of the invention the dissipation of heat to the substrate or to the grating during the growth process is actively influenced by means of heating the substrate or the grating. In Figure 4 an example is shown where additional halogen lamps 20 are arranged approximately halfway along the casting frame 2 below the substrate band 8. In Figure 4 the elements that have already been shown in Figure 1 have the same reference numerals as in Figure 1. The halogen lamps 20 heat the substrate band 8 so that the temperature of the crystallised silicon 16 is also increased at the location. Mirrors 22 are arranged below the halogen lamps 20 so that the radiation from the halogen lamps 20 is used more effectively. Preferably a thin substrate band 8 is used so that this has a low thermal capacity in order to be able to achieve a rapid reaction time for the process. Because the crystallised silicon 16 is actively heated on the underside, the quantity of heat dissipated will fall where the halogen lamp heats the substrate band 8. The consequence is that the crystal growth speeds falls at that location. The dissipation of heat in the direction of movement of the substrate band 8 can be regulated by suitable arrangement of heating elements, such as the halogen lamps 20.

In one embodiment of the method the process parameters are so chosen that the crystal growth speed varies during the growth process from approximately 10 mm/sec to approximately 10 $\mu$m/sec. Good results are achieved with these values.

It will be understood that on reading the above variants will be immediately apparent to those skilled in the art. Instead of gallium, aluminium, indium or group V elements can also be used. Such variants are considered to fall within the scope of the application as described in appended claims.

## Claims

1. Method of producing a crystalline semiconductor foil with an integrated electric field, comprising:

- doping a fluid semiconductor with a doping substance having an equilibrium segregation coefficient $k_0$ where $k_0 < 0.01$,
- filling a casting frame (2) with the fluid semiconductor (4);
- drawing a foil from the casting frame containing said fluid semiconductor in a production direction by passing a substrate band (8) underneath the casting frame, wherein the substrate band has a lower temperature than the fluid semiconductor in the bottom of the casting frame, so that

a bottom layer of the fluid semiconductor crystallises on the substrate band (8) as a crystallized layer (16) and the semiconductor foil is produced on the substrate band on one side of the casting frame **characterised by**:

- cooling said fluid semiconductor in such a way that the crystallised layer (16) is thicker at the output end of the casting frame (2) and the crystal growth speed decreases in a direction essentially perpendicular to the substrate band (8), by keeping the respective temperature of the substrate (8) and the fluid semiconductor to be supplied constant for creating a gradient doping profile in the crystalline semiconductor foil that has a desired high value on one side of the foil.

**2.** Method according to claim 1, wherein heat of crystallisation from the crystallization process is dissipated so rapidly that an initial crystal growth speed is so high that the effective segregation coefficient $k_{eff}$ is virtually equal to 1.

**3.** Method according to claim 1, wherein dissipation of heat to the substrate band during the growth process is actively influenced by means of heating the substrate band.

**4.** Method according to one of the preceding claims, wherein the doping substance is one of gallium, aluminium, indium and group V elements.

**5.** Method according to one of the preceding claims, wherein during crystallisation of the foil the crystal growth speed varies between 10 mm/sec to 10 $\mu$m/sec.

**Patentansprüche**

**1.** Verfahren zur Herstellung einer kristallinen Halbleiter-folie mit einem integrierten elektrischen Feld, das umfasst:

- Dotieren eines fluiden Halbleiters mit einer Dotierungssubstanz mit einem Gleichgewichtssegregationskoeffizienten $k_0$, wobei $k_0 < 0,01$ ist,
- Füllen eines Gussrahmens (2) mit dem fluiden Halbleiter (4),
- Ziehen einer Folie aus dem Gussrahmen, der den fluiden Halbleiter enthält, in eine Produktionsrichtung durch Führen eines Substratbandes (8) unterhalb des Gussrahmens, wobei das Substratband eine niedrigere Temperatur aufweist als der fluide Halbleiter in dem Boden des Gussrahmens, so dass eine Bodenschicht des fluiden Halbleiters auf dem Substratband (8) als eine kristallisierte Schicht (16) kristallisiert, und die Halbleiterfolie auf dem Substratband auf einer Seite des Gussrahmens erzeugt wird,

**gekennzeichnet durch**

- Kühlen des fluiden Halbleiters auf eine solche Weise, dass die kristallisierte Schicht (16) an den Auslassenden des Gussrahmens (2) dicker ist und die Kristallwachstumsgeschwindigkeit in einer im Wesentlichen senkrechten Richtung zu dem Substratband (8) abnimmt, durch Konstanthalten der Temperatur des Substrats (8) beziehungsweise des zuzuführenden fluiden Halbleiters, um ein abfallendes Dotierungsprofil in der kristallinen Halbleiterfolie zu erzeugen, das einen gewünschten hohen Wert auf einer Seite der Folie aufweist.

**2.** Verfahren nach Anspruch 1, bei dem die Kristallisationswärme des Kristallisationsvorgangs sich so schnell verteilt, dass eine anfängliche Kristallwachstumsgeschwindigkeit so hoch ist, dass der effektive Segregationskoeffizient $k_{eff}$ nahezu gleich 1 ist.

**3.** Verfahren nach Anspruch 1, bei dem Verteilung von Wärme zu dem Substratband während des Wachstumsvorgangs aktiv mittels Erwärmen des Substratbandes beeinflusst wird.

**4.** Verfahren nach einem der vorhergehenden Ansprüche bei dem die Dotierungssubstanz eine von Gallium, Aluminium, Indium und Gruppe-V-Elementen ist.

**5.** Verfahren nach einem der vorhergehenden Ansprüche bei dem die Kristallwachstumsgeschwindigkeit während der Kristallisation der Folie von 10 mm/s bis 10 $\mu$m/s variiert.

**Revendications**

**1.** Procédé de fabrication d'une feuille semi-conductrice cristalline à champ électrique intégré, comprenant les étapes consistant à :

- doper un semi-conducteur fluide avec une substance dopante ayant un coefficient de ségrégation à l'équilibre $k_0$, où $k_0 < 0,01$,
- remplir un cadre de coulée (2) avec le semi-conducteur fluide (4) ;
- tirer une feuille du cadre de coulée contenant ledit semi-conducteur fluide dans une direction de production en faisant passer une bande de substrat (8) sous le cadre de coulée, dans lequel la bande de substrat a une température inférieure à celle du semi-conducteur fluide dans la partie inférieure du cadre de coulée, de sorte qu'une couche inférieure du semi-conducteur fluide cristallise sur la bande de substrat (8) en tant que couche cristallisée (16) et que la feuille de semi-conducteur est produite sur la bande de substrat sur un côté du cadre de coulée ;

**caractérisé par** l'étape consistant à :

- refroidir ledit semi-conducteur fluide de manière à ce que la couche cristallisée (16) soit plus épaisse à l'extrémité de sortie du cadre de coulée (2) et que la vitesse de croissance des cristaux diminue dans une direction essentiellement perpendiculaire à la bande de substrat (8), en maintenant constantes la température respective du substrat (8) et du fluide semi-conducteur à alimenter pour créer un profil de dopage à gradient dans la feuille semi-conductrice cristalline qui présente une valeur élevée souhaitée sur un côté de la feuille.

2. Procédé selon la revendication 1, dans lequel la chaleur de cristallisation issue du processus de cristallisation est dissipée si rapidement qu'une vitesse de croissance initiale des cristaux est si élevée que le coefficient de ségrégation effectif $k_{eff}$ est pratiquement égal à 1.

3. Procédé selon la revendication 1, dans lequel la dissipation de chaleur dans la bande de substrat pendant le processus de croissance est activement influencée par le chauffage de la bande de substrat.

4. Procédé selon l'une des revendications précédentes, dans lequel la substance dopante est l'un du gallium, de l'aluminium, de l'indium et des éléments du groupe V.

5. Procédé selon l'une des revendications précédentes, dans lequel pendant la cristallisation de la feuille, la vitesse de croissance des cristaux varie entre 10 mm/s et 10 $\mu$m/s.

## Fig 1

## Fig 2

8

*Fig 3*

*Fig 4*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4554203 A

- US 4690797 A

**Non-patent literature cited in the description**

- Effect of doping gradients on solar cell efficiency. **BELL R.O. et al.** Photovoltaic specialists conference. IEEE, 21 October 1985, vol. 1, 764-769
- Boron doping of silicon layers grown by liquid phase epitaxy. **MCCANN M.J. et al.** Journal of crystal growth. North-Holland Publishing co, May 2002, 45-50

- **J. P. KALEJS.** An overview of new developments in crystalline silicon ribbon material technology for solar cells. *proceedings of the third world conference on photovoltaic energy conversion,* 11 May 2003